# EUROPEAN PATENT APPLICATION

(11) **EP 3 133 644 A1**
(43) Date of publication of application: **22.02.2017**
(21) Application number: 16176438.6
(22) Date of filing: 27.06.2016
(51) Int. Cl.: H01L 23/498, H01L 23/485

(54) **BALL GRID ARRAY PACKAGES INCLUDING A HEXAGONAL BALL ARRAY**

(30) Priority: 17.08.2015 US 201562205786 P; 14.06.2016 US 201615182581
(71) Applicant: MediaTek Inc., Hsin-Chu 300 (TW)
(72) Inventor: LIN, Tzu-Hung, Zhubei City, Hsinchu County 302 (TW); HSIAO, Ching-Wen, Hsinchu City 300 (TW); PENG, I-Hsuan, Hsinchu City 300 (TW); LIU, Nai-Wei, Kaohsiung City 830 (TW)
(74) Representative: Hoefer & Partner Patentanwälte mbB

(57) **Abstract**

A ball grid array (BGA) (100a) for an integrated circuit package (1) includes an array of connection points (502) derived from a base unit of hexagonal pattern repeated in at least one or more sections of the integrated circuit package (1), increasing the density of the connection points (502) and providing higher escape routing. According to one embodiment, the connection points (502) are solder balls (50) mounted on a lower surface of the integrated circuit package (1). The ball grid array (100a) may contain the hexagonal array in a second region (102) and an array of connection points (501) arranged in a square grid-shaped or a rectangular pattern in a first region (101), wherein the connection point pitches in the first and second regions (101, 102) may be the same or different. The teaching is applicable to all types of packages which include a BGA, including a chip scale package (CSP) BGA, a ceramic BGA (CBGA), a land grid array (LGA) package, fan-out packages or package-on-package (PoP).

## Description

### Background

The present invention is related in general to the field of semiconductor devices, and more specifically to structure and layout of ball grid array (BGA) packages, which is capable of accommodating maximum number of balls (or bumps) for a given area of a package at a predetermined pitch.

For the packages of semiconductor chips, the increasing product complexity typically translates into larger numbers of required input/output (I/O) terminals for signals and power, while the cost pressure calls against increase in package size. As an example, the popular ball grid array (BGA) package responded to these contradictory requirements by increasing the number of balls while reducing the ball size and the pitch between balls.

A ball grid array (BGA) includes an array of balls of solder that are affixed to pins on the bottom of an integrated circuit (IC) package for electrically connecting the IC package to a printed circuit board (PCB). The IC package may then be placed on the PCB, which has copper conductive pads in a pattern that matches the array of solder balls on the IC package. The solder balls may be heated to cause the solder balls to melt. When the solder cools and solidifies, the hardened solder mechanically attaches the IC package to the PCB.

There is a constant need in this industry to provide an improved structure or layout of ball grid array packages in order to comport with the trend of semiconductor packages that are small, compact, light and thin. There is also a constant need in this industry to provide an improved structure or layout for ball grid array packages, which is able to accommodate maximum number of balls within a limited surface area of a package at a predetermined pitch.

### Summary

This in mind, the present invention aims at providing an improved ball grid array for an integrated circuit (IC) package, which is able to increase ball density and provide higher escape routing.

This is achieved by a ball grid array for an integrated circuit package according to the pre-characterizing clause of claim 1. The dependent claims pertain to corresponding further developments and improvements.

As will be seen more clearly from the detailed description following below, the ball grid array for an integrated circuit package includes an array of connection points derived from a base unit of hexagonal pattern repeated in at least one or more sections of the integrated circuit package. According to one embodiment, the connection points are solder balls mounted on a lower surface of the integrated circuit package.

According to another aspect of the invention, a ball grid array for an integrated circuit package includes a plurality of first connection points in an array within a first region, wherein the array of first connection points are arranged in a square grid-shaped pattern or a rectangle pattern; and a plurality of second connection points in an array within a second region, wherein the array of the second connection points is derived from a repeating base unit of hexagonal pattern. The array of first connection points are arranged at a first pitch and the array of the second connection points are arranged at a second pitch. The first pitch may be different from the second pitch.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention, and are incorporated in and constitute a part of this specification. The drawings illustrate embodiments of the invention and, together with the description, serve to explain the principles of the invention. In the drawings:
FIG. 1 is a schematic, cross-sectional diagram showing an exemplary ball grid array (BGA) package according to one embodiment of the invention;
FIG. 2 is a schematic layout diagram showing the structure of the BGA balls in FIG. 1 according to one embodiment of the invention; and
FIG. 3 is a schematic layout diagram showing a hybrid structure of the BGA balls according to another embodiment of the invention.

### Detailed Description

In the following detailed description of embodiments of the invention, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, chemical, electrical, and procedural changes may be made without departing from the spirit and scope of the present disclosure. The following detailed description is, therefore, not to be taken in a limiting sense, and the scope of embodiments of the present invention is defined only by the appended claims.

The terms "wafer" and "substrate" used herein include any structure having an exposed surface onto which a layer is deposited according to the present disclosure, for example, to form the circuit structure such as a redistribution layer (RDL). The term "substrate" is understood to include semiconductor wafers, but not limited thereto. The term "substrate" is also used to refer to semiconductor structures during processing, and may include other layers that have been fabricated thereupon. The terms "die", "chip", "semiconductor chip", and "semiconductor die" are used interchangeable throughout the specification. The terms "solder balls", "BGA balls", and "balls" are used interchangeable throughout the specification.

It is noted that a package including a BGA in accordance with the teachings of the present invention is described herein for explanation purposes. It is appreciated that the teachings of the present invention are applicable to all types of packages that include a BGA, including a chip scale package (CSP) BGA, a ceramic BGA (CBGA), and the like. For instance, the teachings of the present invention may also be extended to a land grid array (LGA) package. A LGA package is a standard BGA package having no sphere shaped solder balls. Instead the LGA solder interconnect is formed solely by solder paste applied at the substrate of the package forming solder lands instead of solder balls. The present invention is applicable to all types of packages with high I/O pin count, for example, fan-out packages or package-on-package (PoP).

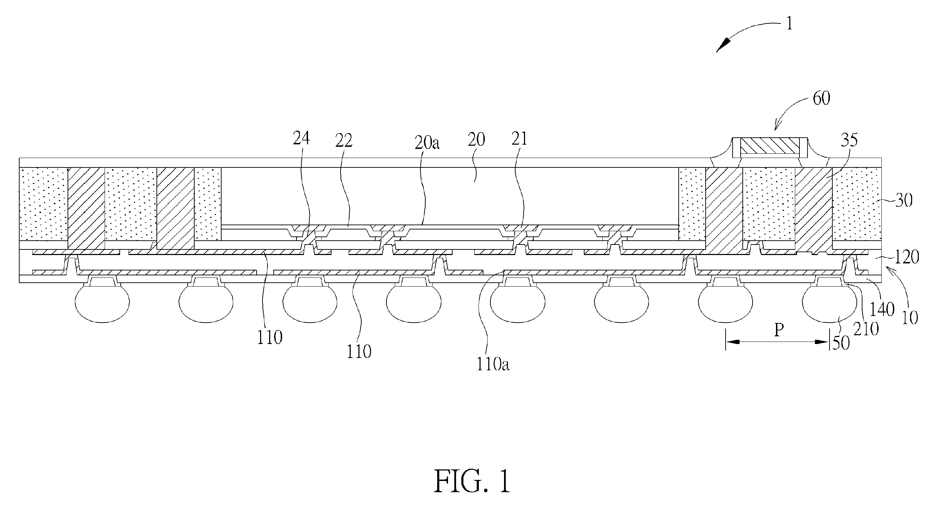

FIG. 1 is a schematic, cross-sectional diagram showing an exemplary ball grid array (BGA) package according to one embodiment of the invention. As shown in FIG. 1, the BGA package 1 comprises a semiconductor die 20 with its active surface 20a facing downward. A plurality of input/output (I/O) pads 21 including, but not limited to, signals pads, ground pads, and power pads, are provided on the active surface 20a. Optionally, the active surface 20a may be covered with a passivation layer 22, for example, silicon nitride, a silicon oxide, or polyimide, but is not limited thereto. The semiconductor die 20 is surrounded by a molding compound 30.

According to one embodiment, a re-wiring structure 10 is provided on a lower surface of the molding compound 30 and the active surface 20a of the semiconductor die 20. According to one embodiment, the re-wiring structure 10 includes, but not limited to, at least a re-distributed layer (RDL) 110 fabricated in a dielectric layer 120. The dielectric layer 120 may be formed of organic materials, which include a polymer base material, non-organic materials, which include silicon nitride (SiN_{X}), silicon oxide (SiO_{X}), graphene, or the like. In some embodiments, the dielectric layer 120 is a high-k dielectric layer (k is the dielectric constant of the dielectric layer). In some other embodiments, the dielectric layer 120 may be formed of a photosensitive material, which includes a dry film photoresist, or a taping film. It is understood that the number of the layers of the re-distributed layer 110 and the dielectric layer 120 depends upon design requirements and is not limited to the layers shown in this figure. According to one embodiment, the semiconductor die 20 may be electrically connected to the re-wiring structure 10 through a plurality of copper bumps 24 formed on the respective I/O pads 21.

According to one embodiment, optionally, a plurality of through mold vias (TMVs) 35 may be provided around the semiconductor die 20. The TMVs 35 may comprise copper pillars or copper posts, but is not limited thereto. The TMVs 35 penetrate through the molding compound 30 and may be electrically connected to the re-wiring structure 10. Optionally, a component 60, for example, a passive component, may be mounted on the molding compound 30 and may be electrically connected to the re-wiring structure 10 through the TMVs 35. In other embodiments, a chip package may be mounted on the molding compound 30 and may be electrically connected to the re-wiring structure 10 through the TMVs 35, thereby forming a package-on-package (PoP) assembly. For example, he aforesaid chip package may be a DRAM chip package comprising a plurality of stacked DRAM dies.

According to one embodiment, on the lower surface of the re-wiring structure 10, a passivation layer (or a solder mask) 140 may be provided. A plurality of openings (not explicitly shown) is provided in the passivation layer 140 to expose respective solder pads (or ball pads) 110a in the RDL 110. A plurality of BGA balls (or solder balls) 50 is disposed on the respective solder pads 110a for further connection. According to one embodiment, the BGA balls 50 are arranged at a predetermined pitch P.

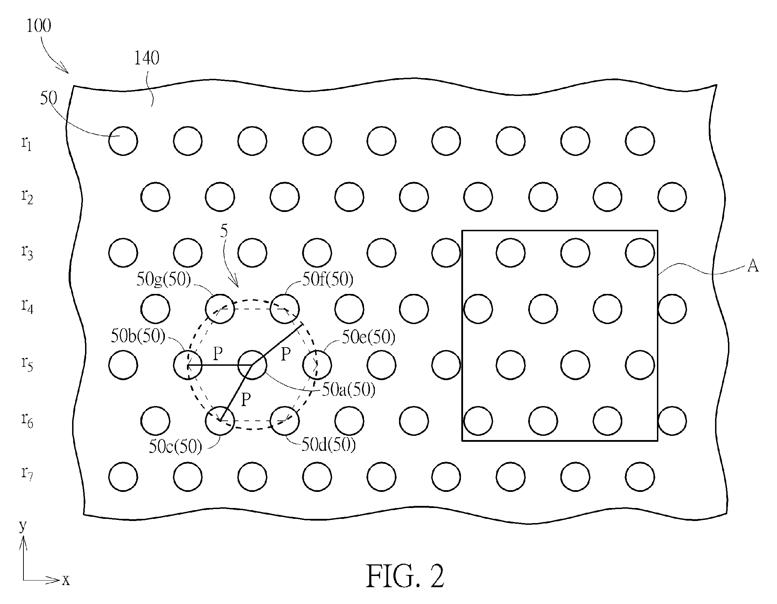

Please refer to FIG. 2 and briefly to FIG. 1. FIG. 2 is a schematic layout diagram showing the structure of the BGA balls 50 in FIG. 1 according to one embodiment of the invention. It is understood that the present invention may be applicable to other layers or any circuit connection points in the BGA package as set forth in FIG. 1, for example, the layout or arrangement of the bumps 24 or bump pad design. As shown in FIG. 2, a layout structure 100 of BGA balls is illustrated. A plurality of balls (e.g. BGA balls) 50 are arranged on the respective solder pads (not shown in this figure) disposed on the lower surface of the BGA package 1. According to one embodiment, the plurality of balls 50 are arranged in an array of staggered pattern.

For the sake of simplicity, only seven rows (r1∼r7) of balls 50 are shown in this figure. According to one embodiment, the odd-number rows r1, r3, r5, r7 are aligned along the reference y-axis and the even-number rows r2, r4, r6 are aligned along the reference y-axis, thereby forming the array of staggered ball pattern. The balls in any two adjacent rows of the seven rows are not aligned along the reference y-axis.

According to one embodiment, the plurality of balls 50 comprises clusters 5 (or base units) of balls repeated in the ball grid array. For example, each of the clusters 5 comprises seven balls 50a∼50g arranged in a base unit of hexagonal pattern. According to one embodiment, the plurality of BGA balls 50 is arranged in an array derived from the base unit of hexagonal pattern consisting of the balls 50a∼50g, which is repeated in at least one or more sections of the lower surface of the BGA package 1.

According to one embodiment, the ball 50a in the central position of the base unit of hexagonal pattern is equidistant to six other balls 50b∼50g. The balls 50a∼50g are arranged at a fixed pitch P. An included angle between centers of any three balls 50 in the cluster 5 is smaller than 90 degrees, for example, sixty degrees. According to one embodiment, the balls in two adjacent rows, for example, r2 and r3, have a minimized pitch P.

The disclosed base unit of hexagonal pattern provides the highest density of BGA balls for a given area, as well as higher escape routing, when compared to a conventional square grid-shaped pattern at the same minimum distance between BGA balls. For example, in FIG. 2, a given area A is able to accommodate 12 balls, while the same given area A can only accommodate 9 balls at the same pitch of conventional square grid-shaped pattern BGA array.

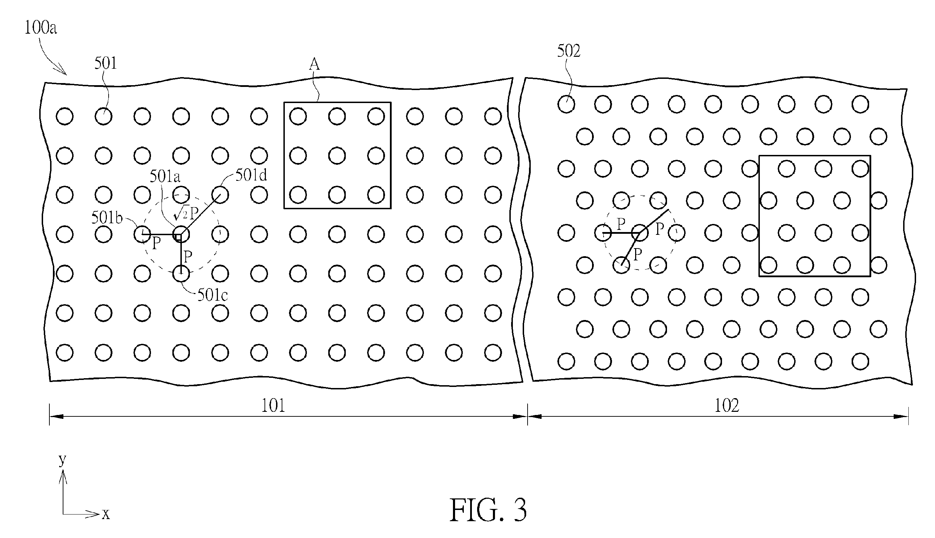

FIG. 3 is a schematic layout diagram showing a hybrid structure or layout of the BGA balls according to another embodiment of the invention. As shown in FIG. 3, a portion of the lower surface of an IC package is illustrated. A hybrid structure of the BGA balls 501 and 502 is disposed on the lower surface of the IC package. According to one embodiment, the BGA balls 501 are arranged in a region 101 and the BGA balls are arranged in a region 102. The region 101 may be in close proximity to the region 102, but is not limited thereto.

According to one embodiment, the BGA balls 501 in the region 101 are arranged in a conventional square grid-shaped pattern or a rectangle pattern. The ball 501a is equidistant to the ball 501b along the reference x-axis, and is equidistant to the ball 501c along the reference y-axis with a predetermined pitch P. The pitch in the reference x-axis is equal to the pitch in the reference y-axis. The 45-degree corner ball 501d is further away by a factor of √2 (square root of 2). According to one embodiment, the BGA balls 502 in the region 102 are arranged in a hexagonal pattern as described in FIG. 2. The balls 502 are also arranged at the predetermined pitch P.

According to one embodiment, the square grid-shaped pattern or a rectangle pattern of balls 501 may be applicable to the region 101 that requires high level of symmetry, but is not limited thereto. According to one embodiment, the hexagonal pattern of balls 502 may be applicable to the region 102 that requires higher ball density, but is not limited thereto. Further, although the pitch in the region 101 and the pitch in the region 102 are the same in the illustrated embodiment, it is understood that the pitch in the region 101 may be different from the pitch in the region 102 in other embodiments.

## Claims

1. A package (1), **characterized by**:
a ball grid array (100) disposed on the package (1), wherein the ball grid array (100) comprises an array of connection points (50) derived from a base unit of hexagonal pattern (5) repeated in at least one or more sections of the integrated circuit package (1).

2. The package (1) according to claim 1, further **characterized in that** the array of connection points (50) are arranged in a staggered pattern.

3. The package (1) according to claim 1, further **characterized in that** the connection points (50) are solder balls mounted on a lower surface of the integrated circuit package (1).

4. The package (1) according to claim 3, further **characterized in that** the solder balls are arranged at a fixed pitch (P).

5. The package (1) according to claim 3, further **characterized in that** the base unit of hexagonal pattern (5) comprises seven balls (50a∼50g) including a central ball (50a) and six other balls (50b∼50g) around the central ball.

6. The package (1) according to claim 5, further **characterized in that** the central ball (50a) is equidistant to said six other balls (50b∼50g).

7. The package (1) according to claim 5, further **characterized in that** an included angle between centers of any three balls of the seven balls (50a∼50g) is less than 90 degrees.

8. The package (1) according to claim 7, further **characterized in that** an included angle between centers of any three balls of the seven balls (50a∼50g) is sixty degrees.

9. A ball grid array (100a) for an integrated circuit package (1), **characterized by**:
a plurality of first connection points (501) in an array within a first region (101), wherein the array of first connection points (501) are arranged in a square grid-shaped pattern or a rectangle pattern; and
a plurality of second connection points (502) in an array within a second region (102), wherein the array of the second connection points (502) is derived from a repeating base unit of hexagonal pattern.

10. The ball grid array (100a) for an integrated circuit package (1) according to claim 9, further **characterized in that** the array of first connection points (501) are arranged at a first pitch and the array of the second connection points (502) are arranged at a second pitch.

11. The ball grid array (100a) for an integrated circuit package (1) according to claim 10, further **characterized in that** the first pitch and the second pitch are the same.

12. The ball grid array (100a) for an integrated circuit package (1) according to claim 10, further **characterized in that** the first pitch is different from the second pitch.
